(19) Europäisches Patentamt
European Patent Office
Office européen des brevets

(11)  EP 4 220 198 B1

(12)  **FASCICULE DE BREVET EUROPEEN**

(45) Date de publication et mention
de la délivrance du brevet:
**15.05.2024  Bulletin 2024/20**

(51) Classification Internationale des Brevets (IPC):
***G01R 22/06*** *(2006.01)*      ***G01R 35/00*** *(2006.01)*

(21) Numéro de dépôt: **23152744.1**

(52) Classification Coopérative des Brevets (CPC):
**G01R 22/06; G01R 35/005**

(22) Date de dépôt: **20.01.2023**

(54)  **PROCEDE DE REGLAGE D'UN COMPTEUR ELECTRIQUE**

VERFAHREN ZUR EINSTELLUNG EINES ELEKTRISCHEN ZÄHLERS

METHOD FOR ADJUSTING AN ELECTRIC METER

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priorité:  **27.01.2022  FR 2200719**

(43) Date de publication de la demande:
**02.08.2023  Bulletin 2023/31**

(73) Titulaire: **Sagemcom Energy & Telecom SAS
92270 Bois-Colombes (FR)**

(72) Inventeurs:
• **TEBOULLE, Henri
92500 RUEIL MALMAISON (FR)**
• **GRINCOURT, Christophe
92500 RUEIL MALMAISON (FR)**
• **NOIRET, Sébastien
92500 RUEIL MALMAISON (FR)**

(74) Mandataire: **Cabinet Boettcher
5, rue de Vienne
75008 Paris (FR)**

(56) Documents cités:
**US-A- 4 303 881     US-B1- 6 377 037**

EP 4 220 198 B1

**Description**

L'invention concerne le domaine des compteurs électriques.

ARRIERE PLAN DE L'INVENTION

Certains compteurs électriques sont spécifiés et conçus pour pouvoir fonctionner dans plusieurs pays, dont les réseaux de distribution d'énergie électrique ont des fréquences différentes. Ces compteurs doivent mesurer l'énergie électrique distribuée avec des précisions conformes aux réglementations en vigueur dans chacun de ces pays.

Les fréquences de réseau concernées sont typiquement le 50Hz et le 60Hz, et certains compteurs doivent ainsi être à la fois conformes, pour les mesures d'énergie active, à la norme EN 50470-3 dans le cas 50Hz pour être « MID » (pour Measuring Instruments Directive), et pour être conformes à un pays « 60Hz », en l'absence de transformateur de courant externe à la norme IEC 62053-21 et en présence de transformateur de courant externe à la norme IEC 62053-22, et pour les mesures d'énergie réactive à la norme IEC 62053-24 (qui couvre l'absence et la présence de transformateur de courant externe) dans les deux cas « 50Hz » et « 60Hz ».

De manière générale, tous les compteurs électriques sont réglés avec des paramètres de calibration qui sont définis en usine. Les paramètres de calibration sont déterminés pour chaque compteur de manière individuelle à la fin de la phase de fabrication du compteur, et sont enregistrés dans le compteur.

Or, la valeur optimale de certains de ces paramètres de calibration dépend de la fréquence du réseau de distribution.

Pour qu'un compteur soit capable d'assurer les niveaux de précision requis à la fois à 50Hz et à 60Hz, une solution connue consiste à configurer manuellement le compteur à la mise en service (50Hz « Ou Exclusif » 60Hz). Deux lots de paramètres de calibration sont pré-enregistrés dans le compteur, un pour le 50Hz et un pour le 60Hz, afin de ne pas perdre en précisions métrologiques que l'on soit dans un cas ou dans l'autre. Un tel compteur est bien considéré comme MID pour la configuration 50Hz.

Cette solution nécessite cependant, lors de la phase de calibration réalisée en usine, d'effectuer des mesures pour produire deux lots de paramètres de calibration (un par fréquence) pour chaque compteur fabriqué. La durée de cette phase de calibration n'est pas négligeable (typiquement de l'ordre de la dizaine de minutes par compteur et par fréquence), et cette solution augmente donc significativement le coût de fabrication de chaque compteur.

Une autre solution connue consiste à concevoir des compteurs prévus pour fonctionner sur une large plage de fréquence réseau (45Hz à 65Hz typiquement), et qui sont donc compatibles avec les fréquences de 50Hz et de 60Hz sans nécessiter de configuration ni de réglage à la mise en service. Ces compteurs ont donc des paramètres de calibration « médians », ce qui amène à des dégradations de précisions métrologiques par rapport à un compteur purement 50Hz ou purement 60Hz.

US 6 377 037 B1 divulgue un compteur électrique configuré pour utiliser des paramètres de calibration calculés pour une fréquence de réseau de 60Hz et pour recalculer ces paramètres de calibration pour une fréquence de 50Hz. Les paramètres à 50Hz sont obtenus à partir des paramètres à 60Hz et de constantes.

OBJET DE L'INVENTION

L'invention a pour objet de réduire le coût et d'améliorer la précision d'un compteur électrique susceptible d'être connecté à des réseaux de fréquences différentes.

RESUME DE L'INVENTION

En vue de la réalisation de ce but, on propose un procédé de réglage d'un module de mesure d'un compteur électrique relié à un réseau de distribution, comprenant les étapes, mises en oeuvre dans le compteur électrique suite à une installation du compteur électrique dans une position opérationnelle, de :

- acquérir au moins une mesure d'une fréquence du réseau de distribution ;
- si une différence entre la fréquence du réseau de distribution et une première fréquence est inférieure à un premier seuil prédéterminé, régler le module de mesure en utilisant des premiers paramètres de calibration produits et enregistrés dans le compteur électrique au cours d'une phase de calibration réalisée préalablement à l'installation du compteur dans la position opérationnelle ;
- si la différence entre la fréquence du réseau de distribution et la première fréquence est supérieure ou égale au premier seuil prédéterminé, calculer des deuxièmes paramètres de calibration à partir des premiers paramètres de calibration et de paramètres d'adaptation, et régler le module de mesure en utilisant les deuxièmes paramètres de calibration.

Ainsi, à sa mise en service, le compteur électrique mesure la fréquence du réseau de distribution. Si celle-ci est égale ou très proche de la première fréquence, le compteur utilise les premiers paramètres de calibration pour régler le module de mesure. Sinon, le compteur produit des deuxièmes paramètres de calibration qui correspondent à la fréquence mesurée, et utilise les deuxièmes paramètres de calibration pour régler le module de mesure.

Dans les deux cas, le module de mesure du compteur est réglé avec des paramètres de calibration qui sont définis de manière précise, en tenant compte de la fréquence du réseau de distribution auquel est connecté le compteur.

Le compteur est donc capable de réaliser des mesures très précises quelle que soit la fréquence du réseau de distribution. La phase de calibration en usine du compteur est réalisée à une seule fréquence (la première fréquence), ce qui réduit le coût du compteur.

On propose de plus un procédé de réglage tel que précédemment décrit, dans lequel les paramètres d'adaptation comprennent des premiers paramètres d'adaptation évalués à la première fréquence et des deuxièmes paramètres d'adaptation évalués à une deuxième fréquence, la deuxième fréquence étant telle qu'une différence entre la fréquence du réseau de distribution et la deuxième fréquence est inférieure à un deuxième seuil prédéterminé.

On propose de plus un procédé de réglage tel que précédemment décrit, dans lequel, pour chaque phase du réseau de distribution, le module de mesure est agencé pour acquérir des mesures d'une tension de phase et d'un courant de phase présents sur ladite phase, le module de mesure comprenant au moins un filtre passe-bas agencé pour supprimer des harmoniques de la tension de phase et du courant de phase de manière à produire une tension de phase en fondamental et un courant de phase en fondamental, les paramètres d'adaptation comprenant des paramètres du filtre passe-bas.

On propose de plus un procédé de réglage tel que précédemment décrit, dans lequel les paramètres du filtre passe-bas comprennent un module à la première fréquence d'une transformée en Z d'une fonction de transfert du filtre passe-bas, et un module à la deuxième fréquence de ladite transformée en Z.

On propose de plus un procédé de réglage tel que précédemment décrit, dans lequel les premiers paramètres de calibration comprennent un premier paramètre $K_{U_1}$ et un premier paramètre $K_{I_1}$, et les deuxièmes paramètres de calibration comprennent un deuxième paramètre $K_{U_2}$ et un deuxième paramètre $K_{I_2}$, qui sont intégrés dans des facteurs multiplicatifs par lesquels la tension de phase en fondamental et le courant de phase en fondamental sont multipliés pour évaluer une puissance réactive brute fournie par le réseau de distribution, le deuxième paramètre $K_{U_2}$ et le deuxième paramètre $K_{I_2}$ étant obtenus en calculant :

$$K_{U_2} = (1 + K_{U_1}) * (|H(Z)_1| \ / \ |H(Z)_2|) - 1$$

$$K_{I_2} = (1 + K_{I_1}) * (|H(Z)_1| \ / \ |H(Z)_2|) - 1,$$

où $|H(Z)_1|$ est le module à la première fréquence de la transformée en Z de la fonction de transfert du filtre passe-bas, et où $|H(Z)_2|$ est le module à la deuxième fréquence de la transformée en Z de la fonction de transfert du filtre passe-bas.

On propose de plus un procédé de réglage tel que précédemment décrit, dans lequel les paramètres du filtre passe-bas comprennent aussi une phase à la première fréquence de ladite transformée en Z et une phase à la deuxième fréquence de ladite transformée en Z.

On propose de plus un procédé de réglage tel que précédemment décrit, le compteur électrique comprenant ou étant relié à un capteur de courant comprenant un transformateur de courant et agencé pour produire les mesures du courant de phase, les paramètres d'adaptation comprenant aussi au moins un paramètre du transformateur de courant.

On propose de plus un procédé de réglage tel que précédemment décrit, dans lequel les paramètres d'adaptation comprennent aussi au moins un paramètre d'au moins un composant électronique d'une chaîne de mesure de courant reliée au transformateur de courant.

On propose de plus un procédé de réglage tel que précédemment décrit, dans lequel le composant électronique est un amplificateur.

On propose de plus un procédé de réglage tel que précédemment décrit, dans lequel les premiers paramètres de calibration comprennent un déphasage avec harmoniques $\Delta\varphi_{1\_Harmoniques}$ et un déphasage en fondamental $\Delta\varphi_{1\_Fondamental}$, et les deuxièmes paramètres de calibration comprennent un déphasage avec harmoniques $\Delta\varphi_{2\_Harmoniques}$ et un déphasage en fondamental $\Delta\varphi_{2\_Fondamental}$, qui peuvent être utilisés par le module de mesure pour évaluer une puissance active compensée et une puissance réactive compensée fournies par le réseau de distribution, le déphasage avec harmoniques $\Delta\varphi_{2\_Harmoniques}$ et le déphasage en fondamental $\Delta\varphi_{2\_Fondamental}$ étant obtenus en calculant :

$$\Delta\phi_{2\_Fondamental} = \Delta\phi_{1\_Fondamental} + (\phi(H(Z))_2 - \phi(H(Z))_1) + (\phi_{Transfo\_2} - \phi_{Transfo\_1}) + (\phi_{Ampli\_2} - \phi_{Ampli\_1})$$

et

$$\Delta\phi_{2\_Harmoniques} = \Delta\phi_{1\_Harmoniques} + (\phi_{Transfo\_2} - \phi_{Transfo\_1}) + (\phi_{Ampli\_2} - \phi_{Ampli\_1})$$

où $\varphi(H(Z))_1$ est la phase à la première fréquence de la transformée en Z, $\varphi(H(Z))_2$ est la phase à la deuxième fréquence de la transformée en Z, $\varphi_{Transfo\_1}$ est une phase à la première fréquence du transformateur de courant, $\varphi_{Transfo\_2}$ est une phase à la deuxième fréquence du transformateur de courant, $\varphi_{Ampli\_1}$ est une phase à la première fréquence de l'amplificateur de la chaîne de mesure de courant, $\varphi_{Ampli\_2}$ est une phase à la deuxième fréquence de l'amplificateur de la chaîne de mesure de courant.

On propose de plus un procédé de réglage tel que précédemment décrit, dans lequel, pour chaque phase du réseau de distribution, le compteur est agencé pour mesurer et échantillonner une tension de phase et un courant de phase présents sur ladite phase, de manière à produire des mesures de la tension de phase et du courant de phase présents sur ladite phase, la fréquence d'échantillonnage étant un multiple de la première fréquence et de la deuxième fréquence.

On propose en outre un compteur électrique, comprenant un module de mesure et un composant de traitement dans lequel est mis en oeuvre le procédé de réglage tel que précédemment décrit.

On propose de plus un programme d'ordinateur comprenant des instructions qui conduisent le composant de traitement du compteur électrique tel que précédemment décrit à exécuter les étapes du procédé de réglage tel que précédemment décrit.

On propose de plus un support d'enregistrement lisible par ordinateur, sur lequel est enregistré le programme d'ordinateur tel que précédemment décrit.

L'invention sera mieux comprise à la lumière de la description qui suit d'un mode de mise en oeuvre particulier non limitatif de l'invention.

BREVE DESCRIPTION DU DESSIN

Il sera fait référence au dessin annexé de l'unique figure :

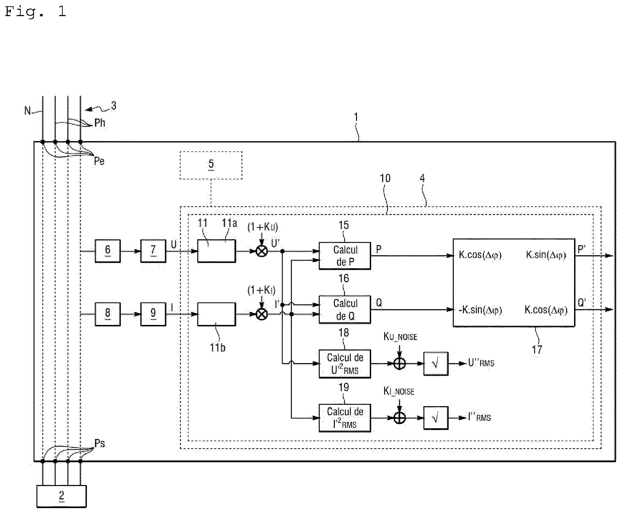

[Fig. 1] la figure 1 représente un compteur électrique dans lequel est mis en oeuvre le procédé de réglage selon l'invention.

DESCRIPTION DETAILLEE DE L'INVENTION

En référence à la figure 1, le compteur électrique 1 selon l'invention est ici un compteur triphasé qui est destiné à mesurer l'énergie électrique fournie à l'installation électrique 2 d'un abonné par un réseau de distribution 3.

Le réseau de distribution 3 comprend trois phases Ph (phase 1, phase 2 et phase 3) et un neutre N.

La fréquence du réseau de distribution peut être soit égale à 50Hz (ou très proche de 50Hz), soit égale à 60Hz (ou très proche de 60Hz).

Le compteur 1 comprend trois ports d'entrée Pe connectés chacun à l'une des phases Ph du réseau de distribution 3, et un port d'entrée Pe connecté au neutre N. Le compteur 1 comporte aussi quatre ports de sortie Ps connectés à l'installation 2 (trois pour les phases et un pour le neutre).

Le compteur 1 comporte une partie applicative et une partie métrologie. On s'intéresse ici à la partie métrologie.

La partie métrologie comprend tout d'abord un composant de traitement, qui est par exemple un processeur « généraliste », un processeur spécialisé dans le traitement du signal (ou DSP, pour *Digital Signal Processor*), un microcontrôleur, ou bien un circuit logique programmable tel qu'un FPGA (pour *Field Programmable Gate Arrays*) ou un ASIC (pour *Application Spécifie Integrated Circuit*).

Le composant de traitement est ici un microcontrôleur 4 (« microcontrôleur métrologie »).

La partie métrologie comprend aussi une ou des mémoires 5, reliées à ou intégrées dans le microcontrôleur 4. Au moins l'une de ces mémoires 5 forme un support d'enregistrement lisible par ordinateur, sur lequel est enregistré un programme d'ordinateur comprenant des instructions qui conduisent le microcontrôleur 4 à exécuter au moins certaines des étapes du procédé de réglage qui sera décrit plus bas.

Outre le microcontrôleur 4, la partie métrologie comprend, pour chaque phase Ph du réseau de distribution 3, un capteur de tension 6, une chaîne de mesure de tension 7 reliée au capteur de tension 6, un capteur de courant 8, une chaîne de mesure de courant 9 reliée au capteur de courant 8, et un module de mesure 10. Sur la figure 1, les éléments 6 à 10 sont représentés pour une phase Ph uniquement, mais le compteur 1 comprend de tels éléments pour chacune des phases Ph. On décrit ici la mise en oeuvre de l'invention pour une seule phase Ph, mais elle est mise en oeuvre de la même manière pour chacune des autres phases Ph.

Le capteur de tension 6 comprend des résistances formant un pont diviseur de tension et permettant de produire, à partir de la tension du réseau 3, une tension inférieure ou égale à 3,3V. La chaîne de mesure de tension 7 comporte un premier convertisseur analogique-numérique. La chaîne de mesure de tension 7 produit des mesures de la tension de phase U présente sur la phase Ph.

Le capteur de courant 8 comprend un transformateur de courant. La chaîne de mesure de courant 9 comprend un deuxième convertisseur analogique-numérique et des composants électroniques comprenant au moins un amplificateur. La chaîne de mesure de courant 9 produit des mesures du courant de phase I circulant sur la phase Ph.

Le module de mesure 10 est un module numérique, qui est implémenté dans le microcontrôleur de métrologie 4 du compteur 1. Le module de mesure 10 est relié à la chaîne de mesure de tension 7 et à la chaîne de mesure de courant 9.

Le module de mesure 10 comprend au moins un filtre passe-bas 11 agencé pour supprimer des harmoniques de la tension de phase et du courant de phase de manière à produire une tension de phase en fondamental et un courant de phase en fondamental.

Le module de mesure 10 comprend en l'occurrence un premier filtre passe-bas 11a, relié à la chaîne de mesure de tension 7, et un deuxième filtre passe-bas 11b, relié à la chaîne de mesure de courant 9.

Le premier filtre passe-bas 11a et le deuxième filtre passe-bas 11b sont ici deux filtres de Butterworth identiques. On considère donc qu'il s'agit d'un même filtre 11 dupliqué.

Pour filtrer le fondamental (pour les tensions et pour les courants, pour la calibration « en fondamental » et pour la mesure de l'énergie réactive), le filtre 11 utilisé est un filtre de Butterworth H(Z) d'ordre 1 identique que l'on soit à 50Hz ou à 60Hz.

La transformée en Z d'un filtre de Butterworth du 1er ordre s'exprime par la relation :

$$H(Z) = \frac{1+Z^{-1}}{1-a.Z^{-1}} \text{ avec } Z = e^{\frac{j.2.\pi.f}{f_E}}$$

Le coefficient « a » du filtre est choisi de manière à avoir une fréquence de coupure à 3dB de 75Hz.

Pour obtenir une fréquence de coupure à 3dB de 75Hz lorsque la fréquence d'échantillonnage $f_E$ = 3000Hz, on choisit :

$$a = 0.833033065947701.$$

Le module de mesure 10 comprend de plus une pluralité de modules de calcul, qui permettent d'évaluer la puissance active, la puissance réactive, la tension RMS (pour *Root Mean Square* ; il s'agit de la valeur efficace) et le courant RMS distribués par le réseau de distribution 3 via la phase Ph. Le module de mesure 10 utilise aussi un certain nombre de paramètres de calibration pour réaliser ces calculs. Les paramètres de calibration sont les suivants : **$K$, $K_U$, $K_I$, $K_{U\_NOISE}$, $K_{I\_NOISE}$,** $\Delta\varphi$.

La tension de phase **U** est multipliée par un facteur multiplicatif intégrant le paramètre de tension **$K_U$**, pour obtenir une tension compensée **U'**. Le facteur multiplicatif est égal à **(1 + $K_U$)**.

Le courant de phase **I** est multiplié par un facteur multiplicatif intégrant le paramètre de courant **$K_I$**, pour obtenir un courant compensé **I'**. Le facteur multiplicatif est égal à **(1 + $K_I$)**.

Le module 15 acquiert la tension compensée **U'** et le courant compensé **I'** et produit une puissance active brute **P.**

Le module 16 acquiert la tension compensée **U'** et le courant compensé **I'** et produit une puissance réactive brute **Q.**

Le module 17, qui se présente sous la forme d'une matrice, acquiert la puissance active brute **P** et la puissance réactive brute **Q** et évalue la puissance active compensée **P'** et la puissance réactive compensée **Q'**, en calculant :

$$P' = K.cos(\Delta\varphi).P + K.sin(\Delta\varphi).Q$$

$$Q' = -K.sin(\Delta\varphi).P + K.cos(\Delta\varphi).Q$$

Le module 18 acquiert la tension compensée **U'** et calcule la tension RMS au carré : $U'^2_{RMS}$. Le paramètre **$K_{U\_NOISE}$** est ajouté à la tension RMS au carré, puis la racine du résultat de cette addition est calculée, pour obtenir la tension RMS compensée $U''_{RMS}$.

Le module 19 acquiert le courant compensé et calcule le courant RMS au carré : $I'^2_{RMS}$. Le paramètre $K_{I\_NOISE}$ est ajouté au courant RMS au carré, puis la racine du résultat de cette addition est calculée, pour obtenir le courant RMS compensé $I''_{RMS}$.

Le paramètre de calibration $K_U$ compense les variations de gain sur la tension de phase, dues aux composants de la chaîne de mesure de tension 7 en sortie du premier convertisseur analogique-numérique (et notamment aux tolérances des valeurs des résistances). Il est appliqué après suppression d'offset pour éviter de mettre un gain sur l'offset.

Le paramètre de calibration $K_I$ compense les variations de gain sur le courant de phase, dues aux composants de la chaîne de mesure de courant 9 en sortie du deuxième convertisseur analogique-numérique (et notamment aux tolérances des valeurs des résistances). Il est appliqué après suppression d'offset pour éviter de mettre un gain sur l'offset.

Les paramètres $K_U$ et $K_I$ sont signés.

Le paramètre de calibration $K_{U\_NOISE}$ compense les effets du bruit blanc intrinsèque au compteur 1, ainsi que le bruit de quantification du premier convertisseur analogique-numérique, sur les mesures de la tension efficace de la phase Ph. On note que, dans la grande majorité des cas, $K_{U\_NOISE} = 0$.

Le paramètre de calibration $K_{I\_NOISE}$ compense les effets du bruit blanc intrinsèque au compteur 1, ainsi que le bruit de quantification du deuxième convertisseur analogique-numérique, sur les mesures du courant efficace de la phase Ph. On a $K_{I\_NOISE} = 0$ en général pour les gammes de forts courants.

Le paramètre de calibration $K$ compense les variations de gain de la chaîne de mesure de tension 7 et de la chaîne de mesure de courant 9.

Le paramètre de calibration $\Delta\varphi$ compense les variations de phase de la chaîne de mesure de tension 7 et de la chaîne de mesure de courant 9, et en particulier celles dues aux transformateurs internes.

Plus généralement, les paramètres $K$ et $\Delta\varphi$ permettent de compenser l'influence sur la mesure des gains et déphasages apportés par l'ensemble du dispositif d'acquisition : capteurs et composants électroniques des chaînes de mesure.

Le module de mesure 10 réalise certains calculs en utilisant la tension de phase $U$ avec harmoniques et le courant de phase $I$ avec harmoniques ; dans ce cas, le module de mesure n'utilise pas les filtres passe-bas 11a, 11b (les filtres sont « by-passés »).

Le module de mesure 10 réalise aussi des calculs en utilisant la tension de phase $U$ en fondamental (sans harmonique) et le courant de phase $I$ en fondamental ; dans ce cas, le module de mesure 10 utilise les filtres passe-bas 11a, 11b. Par exemple, la puissance réactive est mesurée en utilisant la tension de phase et le courant de phase en fondamental. Les filtres passe-bas 11a, 11b sont aussi utilisés, comme on va le voir, pour la calibration « en fondamental ».

Il y a donc en réalité deux jeux de paramètres de calibration (associés à une même fréquence) :

- les paramètres de calibration « avec harmoniques » $K, K_U, K_I, K_{U\_NOISE}, K_{I\_NOISE}, \Delta\varphi$ ;
- les paramètres de calibration « en fondamental » $K, K_U, K_I, K_{U\_NOISE}, K_{I\_NOISE}, \Delta\varphi$.

Les paramètres de calibration « avec harmoniques » sont utilisés en opération, pour régler le module de mesure 10 lorsque celui-ci réalise des mesures « avec harmoniques » - c'est-à-dire sans utiliser les filtres passe-bas 11a, 11b.

Les paramètres de calibration « en fondamental » sont utilisés en opération, pour régler le module de mesure 10 lorsque celui-ci réalise des mesures « en fondamental » - c'est-à-dire en utilisant le premier filtre passe-bas 11a et/ou le deuxième filtre passe-bas 11b.

Habituellement, les paramètres de calibration sont définis puis enregistrés dans le compteur 1 au cours d'une phase de calibration qui a lieu en usine, à la fin de la phase de fabrication du compteur 1, et donc préalablement à sa livraison et à son installation chez le client dans sa position opérationnelle (position de mise en service).

Pour que les mesures réalisées par le compteur 1 soient suffisamment précises, il est indispensable que les paramètres de calibration soient définis en tenant compte de la fréquence du réseau de distribution 3.

Or, comme on l'a vu, il est prévu que le compteur 1 puisse être raccordé à un réseau de distribution ayant une première fréquence, ici égale à 50Hz, ou bien à un réseau de distribution ayant une deuxième fréquence, ici égale à 60Hz.

Au cours de la phase de calibration, les paramètres de calibration sont produits et enregistrés dans le compteur 1 uniquement pour la première fréquence (50Hz) : on les appelle premiers paramètres de calibration.

Le compteur 1 est alors livré, puis installé dans sa position opérationnelle, et activé. L'activation du compteur 1 est suivie par une courte période d'initialisation (de durée égale typiquement à 5s). L'acquisition des mesures métrologiques démarre après cette période d'initialisation.

Le procédé de réglage selon l'invention est mis en oeuvre au cours de la période d'initialisation, et a pour but de définir les paramètres de calibration utilisés pour régler le module de mesure 10.

**EP 4 220 198 B1**

Le microcontrôleur 4 acquiert au moins une mesure de la fréquence du réseau de distribution. Le microcontrôleur 4 peut bien sûr réaliser lui-même cette/ces mesures.

La fréquence mesurée est celle de la tension de phase sur la phase 1. S'il n'y a pas de tension sur la phase 1, le compteur 1 mesure la fréquence sur la phase 2. S'il n'y a pas de tension sur la phase 2, le compteur 1 mesure la fréquence sur la phase 3.

Si la différence entre la fréquence du réseau de distribution 3 et la première fréquence (50Hz) est inférieure à un premier seuil prédéterminé, le microcontrôleur 4 règle le module de mesure 10 en utilisant les premiers paramètres de calibration. Le premier seuil prédéterminé est par exemple compris entre 1Hz et 5Hz.

Si la différence entre la fréquence du réseau de distribution 3 et la première fréquence est supérieure ou égale au premier seuil prédéterminé, le microcontrôleur 4 calcule des deuxièmes paramètres de calibration, et règle le module de mesure 10 en utilisant les deuxièmes paramètres de calibration.

Pour déterminer que la fréquence du réseau de distribution 3 correspond bien au 60Hz, le microcontrôleur 4 vérifie qu'une différence entre la fréquence du réseau de distribution 3 et la deuxième fréquence est inférieure à un deuxième seuil prédéterminé (qui est par exemple égal au premier seuil prédéterminé).

Si c'est le cas, le microcontrôleur 4 calcule les deuxièmes paramètres de calibration à partir des premiers paramètres de calibration et à partir de paramètres d'adaptation.

Les paramètres d'adaptation comprennent des premiers paramètres d'adaptation évalués à la première fréquence et des deuxièmes paramètres d'adaptation évalués à la deuxième fréquence.

On note que, parmi les paramètres de calibration utilisés ici, certains sont indépendants de la fréquence du réseau de distribution 3 (et n'ont donc pas besoin d'être recalculés) : il s'agit des paramètres de calibration « avec harmoniques » $K$, $K_U$, $K_I$, $K_{U\_NOISE}$, $K_{I\_NOISE}$, et des paramètres de calibration « en fondamental » $K$, $K_{U\_NOISE}$, $K_{I\_NOISE}$.

Les paramètres de calibration « en fondamental » $K_U$, $K_I$ dépendent de la fréquence du réseau de distribution 3. Le microcontrôleur 4 produit donc les deuxièmes paramètres de calibration « en fondamental » $K_{U_2}$ et $K_{I_2}$ à partir des premiers paramètres de calibration $K_{U_1}$ et $K_{I_1}$.

De même, le paramètre de calibration « en fondamental » $\Delta\varphi$ dépend de la fréquence du réseau de distribution 3. Le microcontrôleur 4 produit donc le deuxième paramètre de calibration « en fondamental » $\Delta\varphi_{2\_Fondamental}$ (déphasage en fondamental) à partir du premier paramètre de calibration « en fondamental » $\Delta\varphi_{1\_Fondamental}$.

De même, le paramètre de calibration « avec harmoniques » $\Delta\varphi$ dépend de la fréquence du réseau de distribution 3. Le microcontrôleur 4 produit donc le deuxième paramètre de calibration « avec harmoniques » $\Delta\varphi_{2\_Harmoniques}$ (déphasage avec harmoniques) à partir du premier paramètre de calibration « avec harmoniques » $\Delta\varphi_{1\_Harmoniques}$.

Les paramètres d'adaptation comprennent des paramètres du filtre passe-bas 11.

Les paramètres du filtre passe-bas 11 comprennent un module à la première fréquence d'une transformée en Z d'une fonction de transfert du filtre passe-bas 11, et un module à une deuxième fréquence de ladite transformée en Z.

Comme on vient de le voir, les premiers paramètres de calibration comprennent un premier paramètre $K_{U_1}$ et un premier paramètre $K_{I_1}$, et les deuxièmes paramètres de calibration comprennent un deuxième paramètre $K_{U_2}$ et un deuxième paramètre $K_{I_2}$, qui sont intégrés dans des facteurs multiplicatifs par lesquels la tension de phase $U$ en fondamental et le courant de phase $I$ en fondamental sont multipliés pour évaluer une puissance réactive brute $Q$ fournie par le réseau de distribution 3. Le deuxième paramètre $K_{U_2}$ et le deuxième paramètre $K_{I_2}$ sont obtenus en calculant :

$$K_{U_2} = (1 + K_{U_1}) * (|H(Z)_1| \ / \ |H(Z)_2|) - 1$$

$$K_{I_2} = (1 + K_{I_1}) * (|H(Z)_1| \ / \ |H(Z)_2|) - 1,$$

où $|H(Z)_1|$ est le module à la première fréquence de la transformée en Z de la fonction de transfert du filtre passe-bas 11, et où $|H(Z)_2|$ est le module à la deuxième fréquence de la transformée en Z de la fonction de transfert du filtre passe-bas 11.

Les paramètres d'adaptation comprennent donc les modules $|H(Z)_1|$ et $|H(Z)_2|$.

On s'intéresse maintenant à l'obtention de $\Delta\varphi_{2\_Harmoniques}$ et de $\Delta\varphi_{2\_Fondamental}$.

Les paramètres d'adaptation comprennent d'autres paramètres du filtre passe-bas 11, en l'occurrence une phase à la première fréquence de la transformée en Z de la fonction de transfert du filtre passe-bas 11 et une phase à la deuxième fréquence de ladite transformée en Z.

Dans le cas fondamental, on tient donc compte de :

$$\varphi\big(H(Z)\big)_2 - \varphi\big(H(Z)\big)_1,$$

7

où $\varphi(H(Z))_1$ est la phase à la première fréquence de la transformée en Z et $\varphi(H(Z))_2$ est la phase à la deuxième fréquence de la transformée en Z.

Les paramètres d'adaptation comprennent aussi des paramètres du transformateur de courant (du capteur de courant 8).

On prend en compte la différence de déphasage entre la première fréquence (50Hz) et la deuxième fréquence (60Hz) du transformateur de courant :

$$\varphi_{Transfo\_2} - \varphi_{Transfo\_1},$$

où $\varphi_{Transfo\_1}$ est une phase à la première fréquence du transformateur de courant et $\varphi_{Transfo\_2}$ est une phase à la deuxième fréquence dudit transformateur de courant.

Ces paramètres sont fournis par le fabricant ou le fournisseur des transformateurs, et sont donc pré-enregistrés dans le compteur 1.

Les paramètres d'adaptation comprennent aussi des paramètres d'au moins un composant électronique de la chaîne de mesure de courant 9 reliée au transformateur de courant. Ces composants électroniques comprennent un amplificateur.

On prend donc en compte la différence de déphasage entre la première fréquence (50Hz) et la deuxième fréquence (60Hz), mesurée en conception, liée à l'amplificateur opérationnel :

$$\varphi_{Ampli\_2} - \varphi_{Ampli\_1},$$

où $\varphi_{Ampli\_1}$ est une phase à la première fréquence de l'amplificateur de la chaîne de mesure de courant 9 et $\varphi_{Ampli\_2}$ est une phase à la deuxième fréquence dudit amplificateur.

Le microcontrôleur 4 calcule alors :

$$\Delta\phi_{2\_Fondamental} = \Delta\phi_{1\_Fondamental} + (\phi(H(Z))_2 - \phi(H(Z))_1) + (\phi_{Transfo\_2} - \phi_{Transfo\_1}) + (\phi_{Ampli\_2} - \phi_{Ampli\_1})$$

et

$$\Delta\phi_{2\_Harmoniques} = \Delta\phi_{1\_Harmoniques} + (\phi_{Transfo\_2} - \phi_{Transfo\_1}) + (\phi_{Ampli\_2} - \phi_{Ampli\_1})$$

Bien sûr, une fois que le microcontrôleur 4 a « décidé » que les deuxièmes paramètres de calibration doivent être utilisés, ce choix est définitif (la fréquence du réseau ne varie pas significativement), et les deuxièmes paramètres de calibration, une fois définis, sont stockés dans une mémoire (mémoire flash par exemple) de la partie métrologie.

Le compteur 1 calibre donc automatiquement le module de mesure 10 en fonction de la fréquence du réseau de distribution 3.

Comme on l'a vu plus tôt, pour chaque phase Ph, la chaîne de mesure de tension 7 comprend un premier convertisseur analogique-numérique, et la chaîne de mesure de courant 9 comprend un deuxième convertisseur analogique-numérique.

Pour chaque phase Ph, le compteur 1 mesure donc et échantillonne la tension de phase et le courant de phase présents sur ladite phase Ph, pour produire des mesures de la tension de phase $U$ et du courant de phase $I$ présents sur ladite phase Ph. Ces mesures sont ensuite transmises au module de mesure 10.

Avantageusement, la fréquence d'échantillonnage est un multiple de la première fréquence et de la deuxième fréquence. Ici, on échantillonne à 3000Hz, ce qui permet de traiter 60 échantillons par période de 50Hz et 50 échantillons par période de 60Hz. Le fait que cela tombe « juste » permet d'éviter toute fluctuation dans les mesures de puissances et d'énergies sur « une seconde » correspondant à l'échantillonnage de 3000 échantillons.

Bien entendu, l'invention n'est pas limitée au mode de réalisation décrit mais englobe toute variante entrant dans le champ de l'invention telle que définie par les revendications.

On a décrit ici un mode de réalisation particulier, dans lequel les premiers paramètres de calibration (prédéfinis et pré-enregistrés) sont les paramètres à 50Hz, et dans lequel les deuxièmes paramètres de calibration, définis (si nécessaire) lors de la mise en service du compteur, sont les paramètres à 60Hz. Bien sûr, il serait tout à fait possible de calibrer à 60Hz et d'en déduire les paramètres de calibration du 50Hz.

Ce principe peut bien sûr s'appliquer avec d'autres fréquences de réseau que le 50Hz et le 60Hz et pourrait également fonctionner en prenant en compte plus de 2 fréquences de réseau au démarrage, le principe demeurant de déduire, à partir des premiers paramètres de calibration d'une première fréquence, les paramètres de calibration des autres fréquences. Il est alors avantageux de choisir la fréquence d'échantillonnage de manière à ce que le nombre d'échantillons par période soit un nombre entier dans tous les cas. Le coefficient « a » du filtre de Butterworth est alors également adapté.

Les paramètres de calibration utilisés lors de la mise en oeuvre de l'invention peuvent être différents de ceux décrits ici. Par exemple, la matrice 17 n'est pas nécessairement utilisée systématiquement.

Les filtres passe-bas 11a et 11b ne sont pas nécessairement identiques, et ne sont pas nécessairement des filtres de Butterworth. D'autres filtres peuvent être utilisés, tels que le filtre de Tchebychev. Le filtre de Butterworth a l'avantage de « réjecter » assez vite, et de présenter un gain relativement constant dans la bandepassante.

Le compteur électrique dans lequel est mise en oeuvre l'invention n'est bien sûr pas nécessairement un compteur triphasé. Il pourrait s'agir d'un compteur monophasé. Dans ce cas, le schéma de la figure 1 est applicable pour l'unique phase Ph.

## Revendications

1. Procédé de réglage d'un module de mesure (10) d'un compteur électrique (1) relié à un réseau de distribution (3), comprenant les étapes, mises en oeuvre dans le compteur électrique (1) suite à une installation du compteur électrique dans une position opérationnelle, de :

   - acquérir au moins une mesure d'une fréquence du réseau de distribution (3) ;
   - si une différence entre la fréquence du réseau de distribution et une première fréquence est inférieure à un premier seuil prédéterminé, régler le module de mesure (10) en utilisant des premiers paramètres de calibration produits et enregistrés dans le compteur électrique au cours d'une phase de calibration réalisée préalablement à l'installation du compteur dans la position opérationnelle ;
   - si la différence entre la fréquence du réseau de distribution et la première fréquence est supérieure ou égale au premier seuil prédéterminé, calculer des deuxièmes paramètres de calibration à partir des premiers paramètres de calibration et de paramètres d'adaptation, et régler le module de mesure (10) en utilisant les deuxièmes paramètres de calibration, les paramètres d'adaptation comprenant des premiers paramètres d'adaptation évalués à la première fréquence et des deuxièmes paramètres d'adaptation évalués à une deuxième fréquence, la deuxième fréquence étant telle qu'une différence entre la fréquence du réseau de distribution et la deuxième fréquence est inférieure à un deuxième seuil prédéterminé.

2. Procédé de réglage selon la revendication 1, dans lequel, pour chaque phase (Ph) du réseau de distribution (3), le module de mesure (10) est agencé pour acquérir des mesures d'une tension de phase et d'un courant de phase présents sur ladite phase, le module de mesure comprenant au moins un filtre passe-bas (11) agencé pour supprimer des harmoniques de la tension de phase et du courant de phase de manière à produire une tension de phase en fondamental et un courant de phase en fondamental, les paramètres d'adaptation comprenant des paramètres du filtre passe-bas (11).

3. Procédé de réglage selon la revendication 2, dans lequel les paramètres du filtre passe-bas comprennent un module à la première fréquence d'une transformée en Z d'une fonction de transfert du filtre passe-bas, et un module à la deuxième fréquence de ladite transformée en Z.

4. Procédé de réglage selon la revendication 3, dans lequel les premiers paramètres de calibration comprennent un premier paramètre $K_{U_1}$ et un premier paramètre $K_{I_1}$, et les deuxièmes paramètres de calibration comprennent un deuxième paramètre $K_{U_2}$ et un deuxième paramètre $K_{I_2}$, qui sont intégrés dans des facteurs multiplicatifs par lesquels la tension de phase en fondamental et le courant de phase en fondamental sont multipliés pour évaluer une puissance réactive brute fournie par le réseau de distribution, le deuxième paramètre $K_{U_2}$ et le deuxième paramètre $K_{I_2}$ étant obtenus en calculant :

$$K_{U_2} = (1 + K_{U_1}) * (|H(Z)_1| \ / \ |H(Z)_2|) - 1$$

$$K_{I_2} = (1 + K_{I_1}) * (|H(Z)_1| \ / \ |H(Z)_2|) - 1,$$

où $|H(Z)_1|$ est le module à la première fréquence de la transformée en Z de la fonction de transfert du filtre passe-bas (11), et où $|H(Z)_2|$ est le module à la deuxième fréquence de la transformée en Z de la fonction de transfert du filtre passe-bas (11).

5. Procédé de réglage selon la revendication 3, dans lequel les paramètres du filtre passe-bas comprennent aussi une phase à la première fréquence de ladite transformée en Z et une phase à la deuxième fréquence de ladite transformée en Z.

6. Procédé de réglage selon la revendication 5, le compteur électrique (1) comprenant ou étant relié à un capteur de courant (8) comprenant un transformateur de courant et agencé pour produire les mesures du courant de phase, les paramètres d'adaptation comprenant aussi au moins un paramètre du transformateur de courant.

7. Procédé de réglage selon la revendication 6, dans lequel les paramètres d'adaptation comprennent aussi au moins un paramètre d'au moins un composant électronique d'une chaîne de mesure de courant (9) reliée au transformateur de courant.

8. Procédé de réglage selon la revendication 7, dans lequel le composant électronique est un amplificateur.

9. Procédé de réglage selon la revendication 8, dans lequel les premiers paramètres de calibration comprennent un déphasage avec harmoniques $\Delta\varphi_{1\_Harmoniques}$ et un déphasage en fondamental $\Delta\varphi_{1\_Fondamental}$, et les deuxièmes paramètres de calibration comprennent un déphasage avec harmoniques $\Delta\varphi_{2\_Harmoniques}$ et un déphasage en fondamental $\Delta\varphi_{2\_Fondamental}$, qui sont utilisés par le module de mesure (10) pour évaluer une puissance active compensée et une puissance réactive compensée fournies par le réseau de distribution (3), le déphasage avec harmoniques $\Delta\varphi_{2\_Harmoniques}$ et le déphasage en fondamental $\Delta\varphi_{2\_Fondamental}$ étant obtenus en calculant :

$$\Delta\phi_{2\_Fondamental} = \Delta\phi_{1\_Fondamental} + (\phi(H(Z))_2 - \phi(H(Z))_1) + (\phi_{Transfo\_2} - \phi_{Transfo\_1}) + (\phi_{Ampli\_2} - \phi_{Ampli\_1})$$

et

$$\Delta\phi_{2\_Harmoniques} = \Delta\phi_{1\_Harmoniques} + (\phi_{Transfo\_2} - \phi_{Transfo\_1}) + (\phi_{Ampli\_2} - \phi_{Ampli\_1})$$

où $\varphi(H(Z))_1$ est la phase à la première fréquence de la transformée en Z, $\varphi(H(Z))_2$ est la phase à la deuxième fréquence de la transformée en Z, $\varphi_{Transfo\_1}$ est une phase à la première fréquence du transformateur de courant, $\varphi_{Transfo\_2}$ est une phase à la deuxième fréquence du transformateur de courant, $\varphi_{Ampli\_1}$ est une phase à la première fréquence de l'amplificateur de la chaîne de mesure de courant, $\varphi_{Ampli\_2}$ est une phase à la deuxième fréquence de l'amplificateur de la chaîne de mesure de courant.

10. Procédé de réglage selon la revendication 1, dans lequel, pour chaque phase (Ph) du réseau de distribution (3), le compteur (1) est agencé pour mesurer et échantillonner une tension de phase et un courant de phase présents sur ladite phase, de manière à produire des mesures de la tension de phase et du courant de phase présents sur ladite phase, la fréquence d'échantillonnage étant un multiple de la première fréquence et de la deuxième fréquence.

11. Compteur électrique (1), comprenant un module de mesure (10) et un composant de traitement (4) dans lequel est mis en oeuvre le procédé de réglage selon l'une des revendications précédentes.

12. Programme d'ordinateur comprenant des instructions qui conduisent le composant de traitement (4) du compteur électrique (1) selon la revendication 11 à exécuter les étapes du procédé de réglage selon l'une des revendications 1 à 10.

13. Support d'enregistrement lisible par ordinateur, sur lequel est enregistré le programme d'ordinateur selon la revendication 12.

**Patentansprüche**

1. Verfahren zur Einstellung eines Messmoduls (10) eines Stromzählers (1), der mit einem Verteilungsnetz (3) verbunden ist, umfassend die Schritte, durchgeführt in dem Stromzähler (1) nach einer Installation des Stromzählers in einer Betriebsposition:

- Erfassen mindestens einer Messung einer Frequenz des Verteilungsnetzes (3);

- wenn eine Differenz zwischen der Frequenz des Verteilungsnetzes und einer ersten Frequenz geringer als ein erster vorbestimmter Schwellenwert ist, Einstellen des Messmoduls (10), indem erste Kalibrierungsparameter verwendet werden, die in dem Stromzähler während einer Kalibrierungsphase erzeugt und gespeichert werden, die vor der Installation des Zählers in der Betriebsposition durchgeführt wird;

- wenn die Differenz zwischen der Frequenz des Verteilungsnetzes und der ersten Frequenz größer oder gleich dem ersten vorbestimmten Schwellenwert ist, Berechnen von zweiten Kalibrierungsparametern anhand der ersten Kalibrierungsparameter und von Adaptionsparametern, und Einstellen des Messmoduls (10), indem die zweiten Kalibrierungsparameter verwendet werden, wobei die Adaptionsparameter erste Adaptionsparameter umfassen, die bei der ersten Frequenz evaluiert werden, und zweite Adaptionsparameter, die bei einer zweiten Frequenz evaluiert werden, wobei die zweite Frequenz derart ist, dass eine Differenz zwischen der Frequenz des Verteilungsnetzes und der zweiten Frequenz geringer als ein zweiter vorbestimmter Schwellenwert ist.

2. Verfahren zur Einstellung nach Anspruch 1, bei dem für jede Phase (Ph) des Verteilungsnetzes (3) das Messmodul (10) ausgebildet ist, Messungen einer Phasenspannung und eines Phasenstroms zu erfassen, die auf der genannten Phase vorhanden sind, wobei das Messmodul mindestens ein Tiefpassfilter (11) umfasst, das ausgebildet ist, Harmonische der Phasenspannung und des Phasenstroms zu unterdrücken, um eine Phasenspannung in der Grundfrequenz und einen Phasenstrom in der Grundfrequenz zu erzeugen, wobei die Adaptionsparameter Parameter des Tiefpassfilters (11) umfassen.

3. Verfahren zur Einstellung nach Anspruch 2, bei dem die Parameter des Tiefpassfilters einen Modul bei der ersten Frequenz einer Z-Transformierten einer Transferfunktion des Tiefpassfilters und einen Modul bei der zweiten Frequenz der genannten Z-Transformierten umfassen.

4. Verfahren zur Einstellung nach Anspruch 3, bei dem die ersten Kalibrierungsparameter einen ersten Parameter $K_{U_1}$ und einen ersten Parameter $K_{I_1}$ umfassen, und die zweiten Kalibrierungsparameter einen zweiten Parameter $K_{U_2}$ und einen zweiten Parameter $K_{I_2}$ umfassen, die in Multiplikationsfaktoren integriert sind, mit denen die Phasenspannung in der Grundfrequenz und der Phasenstrom in der Grundfrequenz multipliziert werden, um eine Rohblindleistung zu evaluieren, die von dem Verteilungsnetz geliefert wird, wobei der zweite Parameter $K_{U_2}$ und der zweite Parameter $K_{I_2}$ erhalten werden, indem berechnet wird:

$$K_{U_2} = (1 + K_{U_1}) * (|H(Z)_1| \; / \; |H(Z)_2|) - 1$$

$$K_{I_2} = (1 + K_{I_1}) * (|H(Z)_1| \; / \; |H(Z)_2|) - 1,$$

wobei $|H(Z)_1|$ der Modul bei der ersten Frequenz der Z-Transformierten der Transferfunktion des Tiefpassfilters (11) ist und wobei $|H(Z)_2|$ der Modul bei der zweiten Frequenz der Z-Transformierten der Transferfunktion des Tiefpassfilters (11) ist.

5. Verfahren zur Einstellung nach Anspruch 3, bei dem die Parameter des Tiefpassfilters auch eine Phase bei der ersten Frequenz der genannten Z-Transformierten und eine Phase bei der zweiten Frequenz der genannten Z-Transformierten umfassen.

6. Verfahren zur Einstellung nach Anspruch 5, wobei der Stromzähler (1) einen Stromsensor (8) umfasst oder damit verbunden ist, wobei der Stromsensor einen Stromtransformator umfasst und ausgebildet ist, die Messungen des Phasenstroms zu erzeugen, wobei die Adaptionsparameter auch mindestens einen Parameter des Stromtransformators umfassen.

7. Verfahren zur Einstellung nach Anspruch 6, bei dem die Adaptionsparameter auch mindestens einen Parameter mindestens einer elektronischen Komponente einer Strommesskette (9) umfassen, die mit dem Stromtransformator verbunden ist.

8. Verfahren zur Einstellung nach Anspruch 7, bei dem die elektronische Komponente ein Verstärker ist.

9. Verfahren zur Einstellung nach Anspruch 8, bei dem die ersten Kalibrierungsparameter eine Phasenverschiebung mit Harmonischen $\Delta\varphi_{1\_Harmoniques}$ und eine Phasenverschiebung in der Grundfrequenz $\Delta\varphi_{1\_Fondamental}$ umfassen, und die zweiten Kalibrierungsparameter eine Phasenverschiebung mit Harmonischen $\Delta\varphi_{2\_Harmoniques}$ und eine Phasenverschiebung in der Grundfrequenz $\Delta\varphi_{2\_Fondamental}$ umfassen, die von dem Messmodul (10) verwendet werden, um eine kompensierte Wirkleistung und eine kompensierte Blindleistung, die von dem Verteilungsnetz (3) geliefert werden, zu evaluieren, wobei die Phasenverschiebung mit Harmonischen $\Delta\varphi_{2\_Harmoniques}$ und die Phasenverschiebung in der Grundfrequenz $\Delta\varphi_{2\_Fondamental}$ erhalten werden, indem berechnet wird:

$$\Delta\phi_{2\_Fondamental} = \Delta\phi_{1\_Fondamental} + (\phi(H(Z))_2 - \phi(H(Z))_1) + (\phi_{Transfo\_2} - \phi_{Transfo\_1}) + (\phi_{Ampli\_2} - \phi_{Ampli\_1})$$

und

$$\Delta\phi_{2\_Harmoniques} = \Delta\phi_{1\_Harmoniques} + (\phi_{Transfo\_2} - \phi_{Transfo\_1}) + (\phi_{Ampli\_2} - \phi_{Ampli\_1})$$

wobei $_\varphi(H(Z))_1$ die Phase bei der ersten Frequenz der Z-Transformierten, ist, $_\varphi(H(Z))_2$ die Phase bei der zweiten Frequenz der Z-transformierten ist, $\varphi_{Transfo\_1}$ eine Phase bei der ersten Frequenz des Stromtransformators ist, $\varphi_{Transfo\_2}$ eine Phase bei der zweiten Frequenz des Stromtransformators ist, $\varphi_{Ampli\_1}$ eine Phase bei der ersten Frequenz des Verstärkers der Strommesskette ist, $\varphi_{Ampli\_2}$ eine Phase bei der zweiten Frequenz des Verstärkers der Strommesskette ist.

10. Verfahren zur Einstellung nach Anspruch 1, bei dem für jede Phase (Ph) des Verteilungsnetzes (3) der Zähler (1) ausgebildet ist, eine Phasenspannung und einen Phasenstrom, die auf der genannten Phase vorhanden sind, zu messen und abzutasten, um Messungen der Phasenspannung und des Phasenstroms, die auf der genannten Phase vorhanden sind, zu erzeugen, wobei die Abtastfrequenz ein Mehrfaches der ersten Frequenz und der zweiten Frequenz ist.

11. Stromzähler (1), umfassend ein Messmodul (10) und eine Verarbeitungskomponente (4), in der das Verfahren zur Einstellung nach einem der vorhergehenden Ansprüche durchgeführt wird.

12. Computerprogramm, umfassend Anweisungen, die die Verarbeitungskomponente (4) des Stromzählers (1) nach Anspruch 11 veranlassen, die Schritte des Verfahrens zur Einstellung nach einem der Ansprüche 1 bis 10 durchzuführen.

13. Computerlesbarer Aufzeichnungsträger, auf dem das Computerprogramm nach Anspruch 12 aufgezeichnet ist.

**Claims**

1. An adjustment method for adjusting a measurement module (10) of an electricity meter (1) connected to a distribution grid (3), the method comprising the following steps that are implemented in the electricity meter (10) following installation of the electricity meter in an operating position:

. acquiring at least one measurement of the frequency of the distribution grid (3);
. if the difference between the frequency of the distribution grid and a first frequency is less that a first predetermined threshold, adjusting the measurement module (10) by using first calibration parameters that were produced and stored in the electricity meter during a calibration stage performed prior to installing the meter in the operating position;
. if the difference between the frequency of the distribution grid and the first frequency is greater than or equal to the first predetermined threshold, calculating second calibration parameters from the first calibration parameters and from adaptation parameters, and adjusting the measurement module (10) by using the second calibration parameters, the adaptation parameters comprising first adaptation parameters evaluated at the first frequency and second adaptation parameters evaluated at a second frequency, the second frequency being such that the difference between the frequency of the distribution grid and the second frequency is less that a second predetermined threshold.

2. An adjustment method according to claim 1, wherein, for each phase line (Ph) of the distribution grid (3), the measurement module (10) is arranged to acquire measurements of the phase voltage and of the phase current that are present on said phase line, the measurement module including at least one lowpass filter (11) arranged to suppress harmonics from the phase voltage and from the phase current so as to produce the fundamental phase voltage and the fundamental phase current, the adaptation parameters comprising parameters for the lowpass filter (11).

3. An adjustment method according to claim 2, wherein the parameters for the lowpass filter comprise the modulus at the first frequency of a Z transform of a transfer function of the lowpass filter, and the modulus at the second frequency of said Z transform.

4. An adjustment method according to claim 3, wherein the first calibration parameters comprise first parameters $K_{U_1}$ and $K_{I_1}$, and the second calibration parameters comprise second parameters $K_{U_2}$ and $K_{I_2}$, which parameters are incorporated in multiplication factors used for multiplying the fundamental phase voltage and the fundamental phase current in order to evaluate the raw reactive power supplied by the distribution grid, the second calibration parameters $K_{U_2}$ and $K_{I_2}$ being obtained by calculating:

$$K_{U_2} = (1 + K_{U_1}) * (|H(Z)_1| \ / \ |H(Z)_2|) - 1$$

$$K_{I_2} = (1 + K_{I_1}) * (|H(Z)_1| \ / \ |H(Z)_2|) - 1$$

where $|H(Z)_1|$ is the modulus at the first frequency of the Z transform of the transfer function of the lowpass filter (11), and where $|H(Z)_2|$ is the modulus of the second frequency of the Z transform of the transfer function of the lowpass filter (11).

5. An adjustment method according to claim 3, wherein the parameters for the lowpass filter also comprise its phase at the first frequency of said Z transform, and its phase at the second frequency of said Z transform.

6. An adjustment method according to claim 5, the electricity meter (1) including or being connected to a current sensor (8) that includes a current transformer and that is arranged to produce the measurements of the phase current, the adaptation parameters also comprising at least one parameter for the current transformer.

7. An adjustment method according to claim 6, wherein the adaptation parameters also comprise at least one parameter for at least one electronic component of a current measurement circuit (9) that is connected to the current transformer.

8. An adjustment method according to claim 7, wherein the electronic component is an amplifier.

9. An adjustment method according to claim 8, wherein the first calibration parameters also comprise the phase shift with harmonics $\Delta\varphi_{1_{Harmonics}}$ and the fundamental phase shift $\Delta\varphi_{1_{Fundamental}}$, and the second calibration parameters also comprise the phase shift with harmonics $\Delta\varphi_{2_{Harmonics}}$ and the fundamental phase shift $\Delta\varphi_{2_{Fundamental}}$, which calibration parameters are used by the measurement module (10) to evaluate a compensated active power and a compensated reactive power as delivered by the distribution grid (3), the phase shift with harmonics $\Delta\varphi_{2_{Harmonics}}$ and the fundamental phase shift $\Delta\varphi_{2_{Fundamental}}$ being obtained by calculating:

$$\Delta\varphi_{2_{Fundamental}} = \Delta\varphi_{1_{Fundamental}} + (\varphi(H(Z))_2 - \varphi(H(Z))_1) + (\varphi_{Trans\_2} - \varphi_{Trans\_1}) + (\varphi_{Amp\_2} - \varphi_{Amp\_1})$$

and

$$\Delta\varphi_{2\_Harmonics} = \Delta\varphi_{1\_Harmonics} + (\varphi_{Trans\_2} - \varphi_{Trans\_1}) + (\varphi_{Amp\_2} - \varphi_{Amp\_1})$$

where $\varphi(H(Z))_1$ is the phase of the Z transform at the first frequency, $\varphi(H(Z))_2$ is the phase of the Z transform at the second frequency, $\varphi_{Trans\_1}$ is the phase at the first frequency of the current transformer, $\varphi_{Trans\_2}$ is the phase at the second frequency of the current transformer, $\varphi_{Amp\_1}$ is the phase at the first frequency of the amplifier of the current measurement circuit, and $\varphi_{Amp\_2}$ is the phase at the second frequency of the amplifier of the current measurement circuit.

10. An adjustment method according to claim 1, wherein, for each phase line (Ph) of the distribution grid (3), the meter (1) is arranged to measure and sample the phase voltage and the phase current present on said phase line, so as to produce measurements of the phase voltage and of the phase current present on said phase line, the sampling frequency being a multiple both of the first frequency and of the second frequency.

11. An electricity meter (1) including a measurement module (10) and a processor component (4) in which the adjustment method according to any preceding claim is implemented.

12. A computer program including instructions that cause the processor component (4) of the electricity meter (1) according to claim 11 to execute the steps of the adjustment method according to any one of claims 1 to 10.

13. A computer-readable storage medium storing the computer program according to claim 12.

Fig. 1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6377037 B1